# EUROPEAN PATENT APPLICATION

(11) **EP 1 494 361 A1**
(43) Date of publication of application: **05.01.2005**
(21) Application number: 02718542.0
(22) Date of filing: 11.04.2002
(51) Int. Cl.: H04B 1/04, H03F 3/24, H04B 7/26

(54) **COMMUNICATION APPARATUS**

(71) Applicant: MITSUBISHI DENKI KABUSHIKI KAISHA, Tokyo 100-8310 (JP)
(72) Inventor: HAMADA, N., c/o MITSUBISHI DENKI K.K., Chiyoda-ku, Tokyo 100-8310 (JP)
(74) Representative: Sajda, Wolf E., Dipl.-Phys.
(86) International application number: PCT/JP2002/003631
(87) International publication number: WO 2003/085849

(57) **Abstract**

A control unit (19) reads a control procedure for changing the electric power of a transmit signal from a memory (20). According to the control procedure, the control unit (19) controls a variable gain amplifying unit (13), a power amplification unit (15), a high-frequency selection switch (14), and a switching unit (16).

## Description

### Field of the Invention

The present invention relates to a communication apparatus that adjusts the electric power of a transmit signal according to communication environments.

### Background of the Invention

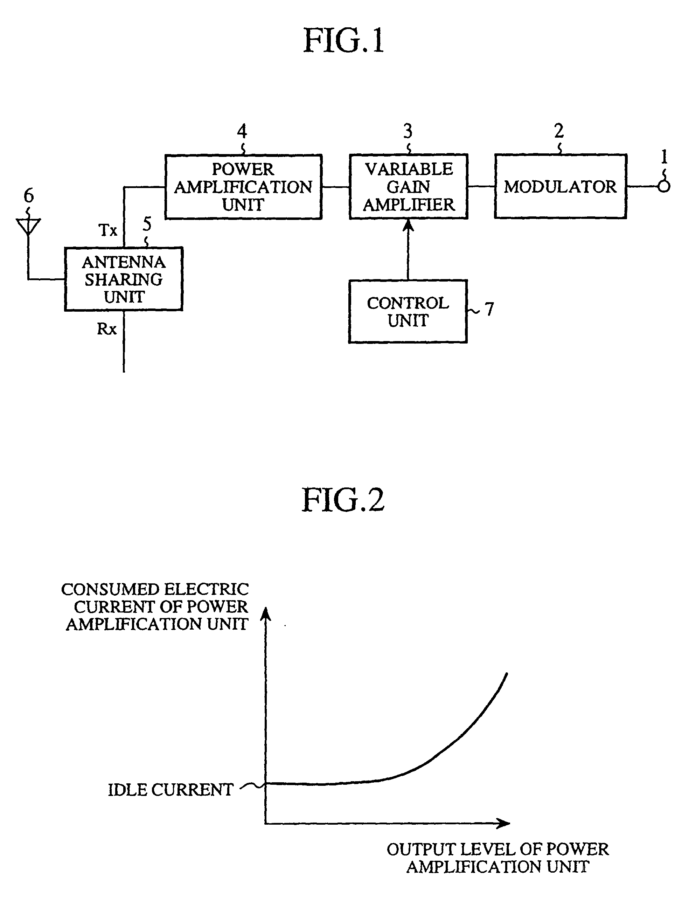

Fig. 1 is a block diagram showing a prior art communication apparatus.

In the figure, reference numeral 1 denotes an input terminal for receiving a transmit signal, reference numeral 2 denotes a modulator for modulating the transmit signal input thereto via the input terminal 1, reference numeral 3 denotes a variable gain amplifying unit having a power gain which is set by a control unit 7, for adjusting the electric power of the transmit signal modulated by the modulator 2, reference numeral 4 denotes a power amplification unit for amplifying the electric power of the transmit signal output thereto from the variable gain amplifying unit 3, reference numeral 5 denotes an antenna sharing unit for outputting the transmit signal output thereto from the power amplification unit 4 to an antenna 6 and for outputting a received signal received by the antenna 6 to the power amplification unit 4, reference numeral 6 denotes the antenna of the communication apparatus, and reference numeral 7 denotes the control unit for controlling the power gain of the variable gain amplifying unit 3.

Fig. 2 is a graphical representation showing a relationship between the level of the output of the power amplification unit 4 and the consumed electric current of the power amplification unit 4.

Next, the operation of the prior art communication apparatus will be explained.

The description is directed to a case where the communication apparatus is installed in a mobile station and transmits information to a base station.

When a transmit signal is input, via the input terminal 1, to the communication apparatus, the modulator 2 modulates the transmit signal in order to convert the transmit signal into a signal suitable for wireless communications.

After the modulator 2 has modulated the transmit signal, the variable gain amplifying unit 3 adjusts the electric power of the modulated transmit signal under the control of the control unit 7 so that the modulated transmit signal has desired electric power.

When then receiving the transmit signal from the variable gain amplifying unit 3, the power amplification unit 4 amplifies the electric power of the transmit signal and outputs it to the antenna sharing unit 5. As a result, the transmit signal is transmitted to the base station by way of the antenna 6.

Although the communication apparatus installed in the mobile station generally adjusts the electric power of the transmit signal according to the distance to the base station and propagation environments, the communication apparatus is rarely used at a maximum output level, and, when the transmit signal has low electric power, is frequently used at about certain output levels which make the consumed electric current of the power amplification unit 4 become constant (see Fig. 2).

Therefore, when the transmit signal has low electric power, since the power supply of the power amplification unit 4 is held in its on state, and the idle current of the power amplification unit 4 cannot be reduced, as shown in Fig. 2, the consumed electric current cannot be reduced effectively even if the transmit signal has low electric power.

A prior art communication apparatus provided with a bypass circuit for delivering a transmit signal output from a variable gain amplifying unit 3 directly to an antenna sharing unit 5 without delivering the transmit signal to a power amplification unit 4, for turning off the power supply of the power amplification unit 4 when the transmit signal has low electric power in order to reduce the consumed electric current effectively is disclosed by Japanese patent application publication No. 9-148,852.

While the prior art communication apparatus constructed as mentioned above can turn off the power supply of the power amplification unit 4 and can reduce the consumed electric current when the transmit signal has low electric power, steep changes in the electric power of the transmit signal can occur when switching from a route passing through the power amplification unit 4 to another route passing through the bypass circuit, or when switching from the other route passing through the bypass circuit to the route passing through the power amplification unit 4. A problem with the prior art communication apparatus is therefore that the band width of the transmit signal increases and this results in interference with other communication links.

The present invention is made in order to solve the above-mentioned problem, and it is therefore an object of the present invention to provide a communication apparatus that can reduce steep changes in the electric power of a transmit signal, thereby reducing the consumed electric current with no degradation in the communication performance.

### Disclosure of the Invention

A communication apparatus in accordance with the present invention includes a preset control procedure for changing the electric power of a transmit signal and a control means for controlling an electric power adjustment means, a power amplification means, and a switching means according to the control procedure.

Therefore, the present embodiment offers an advantage of being able to prevent steep changes in the electric power of the transmit signal, thereby reducing the consumed electric current without degradation in the communication performance.

In the communication apparatus in accordance with the present invention, the control means allows the switching means to change a destination of delivery of the transmit signal from the bypass means to the power amplification means, and also allows the power amplification means to amplify the transmit signal after reducing a power gain of the electric power adjustment means.

Therefore, the present embodiment offers an advantage of being able to prevent steep changes in the electric power of the transmit signal from occurring when raising the electric power of the transmit signal.

In the communication apparatus in accordance with the present invention, the control means allows the switching means to change the destination of the delivery of the transmit signal from the power amplification means to the bypass means after prohibiting the power amplification means from amplifying the transmit signal.

Therefore, the present embodiment offers an advantage of being able to prevent steep changes in the electric power of the transmit signal from occurring when lowering the electric power of the transmit signal.

In the communication apparatus in accordance with the present invention, the power amplification means is comprised of a variable gain amplifying unit and the bypass means is comprised of a variable gain amplifying unit.

Therefore, the present embodiment offers an advantage of being able to significantly reduce the dynamic range of the electric power adjustment means.

In the communication apparatus in accordance with the present invention, the control means gradually changes the electric power of the transmit signal when allowing the switching means to change the destination of the delivery of the transmit signal.

Therefore, the present embodiment offers an advantage of being able to effectively prevent steep changes in the electric power of the transmit signal from occurring when changing the electric power of the transmit signal.

A communication apparatus in accordance with the present invention includes a control means for, when causing a switching means to change a destination of delivery of a transmit signal, checking a format of the transmit signal, determining a switching time when switching the destination of the delivery of the transmit signal according to the format, and causing the switching means to change the destination of the delivery of the transmit signal at the determined switching time.

Therefore, the present invention offers an advantage of being able to reduce the consumed electric current without causing losses in important data which cause big trouble in communications.

In the communication apparatus in accordance with the present invention, when causing the switching means to change the destination of the delivery of the transmit signal, the control means transmits a request for change of the format of the transmit signal.

Therefore, the present invention offers an advantage of being able to reduce the consumed electric current without causing losses in important data which cause big trouble in communications.

A communication apparatus in accordance with the present invention includes a phase correction means for correcting a phase of a transmit signal output to an electric power adjustment means when a switching means changes a destination of delivery of the transmit signal.

Therefore, the present invention offers an advantage of being able to reduce the consumed electric current without causing losses in important data which cause big trouble in communications because phase correction means can reduce changes in the phase of the transmit signal which are incident to the route switching.

### Brief Description of the Figures

Fig. 1 is a block diagram showing a prior art communication apparatus;
Fig. 2 is a graphical representation showing a relationship between the level of an output of a power amplification unit and a consumed electric current;
Fig. 3 is a block diagram showing the structure of a communication apparatus in accordance with embodiment 1 of the present invention;
Fig. 4 is an explanatory drawing showing a relationship between transmitted electric power and a power gain;
Fig. 5 is an explanatory drawing showing an unsuitable control procedure;
Fig. 6 is an explanatory drawing showing a control procedure for raising the electric power of a transmit signal;
Fig. 7 is an explanatory drawing showing a control procedure for lowering the electric power of the transmit signal;
Fig. 8 is a flow chart showing processing performed by the communication apparatus in accordance with embodiment 1 of the present invention;
Fig. 9 is a block diagram showing the structure of a communication apparatus in accordance with embodiment 2 of the present invention;
Fig. 10 is a flow chart showing processing performed by a communication apparatus in accordance with embodiment 4 of the present invention;
Fig. 11 is an explanatory drawing showing timing of switching between routes;
Fig. 12 is an explanatory drawing showing a process of determining a time when changing a destination to which the transmit signal is delivered;
Fig. 13 is an explanatory drawing showing a process of changing a signal format of the transmit signal;
Fig. 14 is an explanatory drawing showing an example of transmission of information indicating the changed signal format;
Fig. 15 is an explanatory drawing showing a process of changing the signal format of the transmit signal;
Fig. 16 is a block diagram showing the structure of a communication apparatus in accordance with embodiment 6 of the present invention; and
Fig. 17 is a flow chart showing processing performed by a communication apparatus in accordance with embodiment 6 of the present invention.

### Preferred Embodiments of the Invention

Hereafter, in order to explain this invention in greater detail, the preferred embodiments of the present invention will be described with reference to the accompanying drawings.

### Embodiment 1.

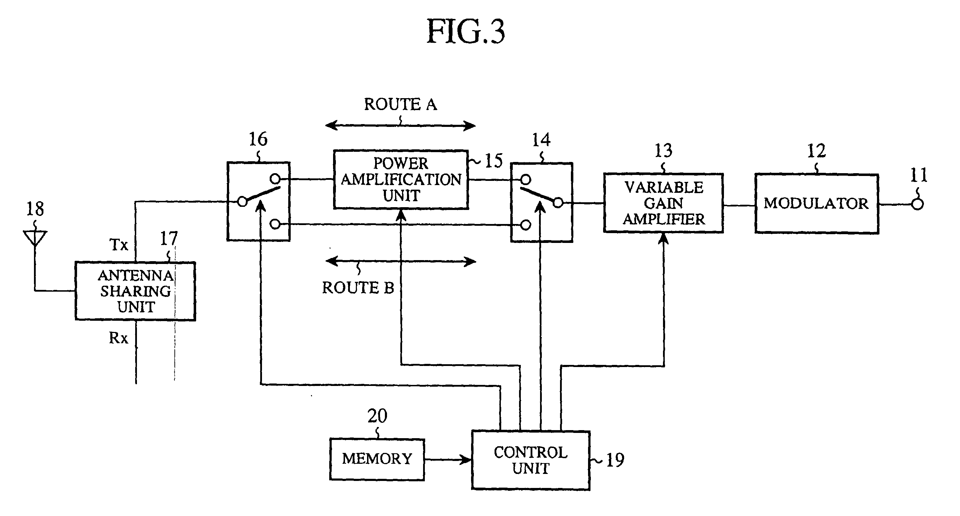

Fig. 3 is a block diagram showing the structure of a communication apparatus in accordance with embodiment 1 of the present invention.

In the figure, reference numeral 11 denotes an input terminal for receiving a transmit signal, reference numeral 12 denotes a modulator for modulating the transmit signal input thereto via the input terminal 11, reference numeral 13 denotes a variable gain amplifying unit (i.e., an electric power adjustment means) having a gain which is set by a control unit 19, for adjusting the electric power of the transmit signal modulated by the modulator 12, reference numeral 14 denotes a high-frequency selection switch for delivering the transmit signal output thereto from the variable gain amplifying unit 13 under the control of the control unit 19 to either a route A or another route B, and reference numeral 15 denotes a power amplification unit (i.e., a power amplification means) disposed on the route A, for amplifying the electric power of the transmit signal output thereto, via the high-frequency selection switch, from the variable gain amplifying unit 13. The power amplification unit 15 is comprised of at least one amplifier. Reference numeral 16 denotes a switching unit for connecting the route A or B to an antenna sharing unit 17 under the control of the control unit 19. A switching means is comprised of the high-frequency selection switch 14 and the switching unit 16.

Reference numeral 17 denotes the antenna sharing unit for outputting the transmit signal output thereto from the switching unit 16 to the antenna 18 and for outputting a received signal received by the antenna 18 to the switching unit 16, reference numeral 18 denotes the antenna of the communication apparatus, reference numeral 19 denotes the control unit (i.e., a control means) for reading a control procedure for changing the electric power of the transmit signal from a memory 20 so as to control the variable gain amplifying unit 13, the power amplification unit 15, the high-frequency selection switch 14, and the switching unit 16 according to the control procedure, and reference numeral 20 denotes the memory in which the control procedure for changing the electric power of the transmit signal is pre-stored.

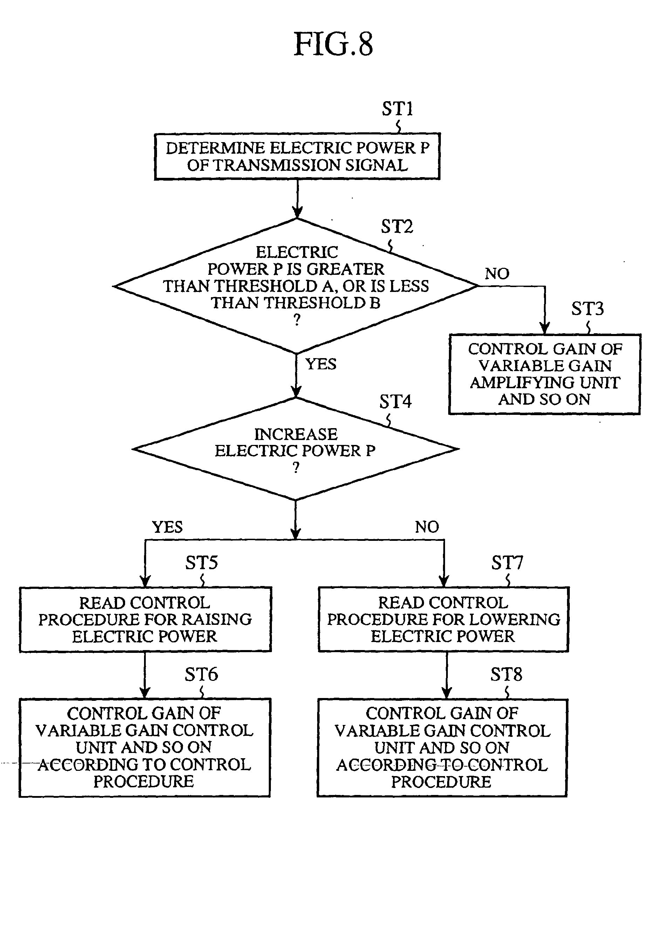

Fig. 8 is a flow chart showing processing performed by the communication apparatus in accordance with embodiment 1 of the present invention.

Next, the operation of the communication apparatus in accordance with embodiment 1 of the present invention will be explained.

The description is directed to a case where the communication apparatus is installed in a mobile station and transmits information to a base station.

When a transmit signal is input, via the input terminal 11, to the communication apparatus, the modulator 12 modulates the transmit signal in order to convert the transmit signal into a signal suitable for wireless communications.

After the modulator 12 has modulated the transmit signal, the variable gain amplifying unit 13 adjusts the electric power of the modulated transmit signal under the control of the control unit 19 (the operation of the control unit 19 will be explained later) so that the modulated transmit signal has desired electric power.

When the high-frequency selection switch 14 and the switching unit 16 select the route A, that is, when the high-frequency selection switch 14 connects the power amplification unit 15 with the variable gain amplifying unit 13 and the switching unit 16 connects the power amplification unit 15 with the antenna sharing unit 17, the power amplification unit 15 amplifies the electric power of the transmit signal output thereto from the variable gain amplifying unit 13 and outputs it to the antenna sharing unit 17.

On the other hand, when the high-frequency selection switch 14 and the switching unit 16 select the other route B, the transmit signal output from the variable gain amplifying unit 13 is delivered directly to the antenna sharing unit 17.

As a result, the transmit signal is transmitted to the base station by way of the antenna 18.

Hereafter, the operation of the control unit 19 will be explained concretely.

The control unit 19 determines the electric power P of the transmit signal first (in step ST1). As an alternative, the electric power P of the transmit signal can be determined by a component other than the control unit 19.

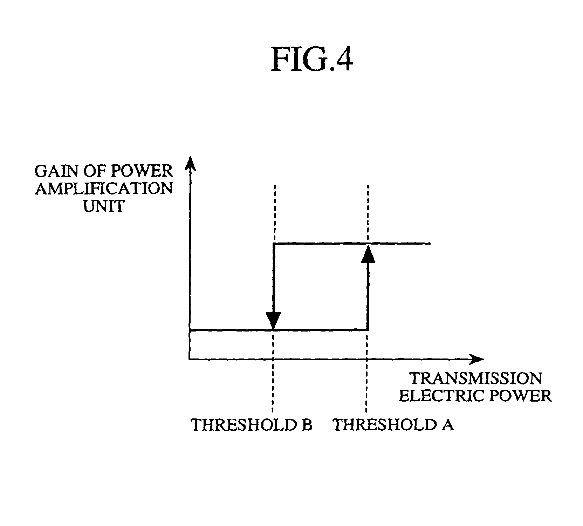

After determining the electric power P of the transmit signal, the control unit 19 compares the electric power P with thresholds A and B (see Fig. 4) (in step ST2).

Then, when determining that the threshold B<= the electric power P <= the threshold A, the control unit 19 outputs no switching commands to both the high-frequency selection switch 14 and the switching unit 16, and maintains the connection with the currently-selected route. In other words, when the route A has been selected the last time and until now, the control unit 19 maintains the selection of the route A. While then determining the power gain of the variable gain amplifying unit 13 according to the electric power P of the transmit signal, the control unit 19 determines one amplifier that is to be powered on from the one or more amplifiers included in the power amplification unit 15 (in step ST3).

In this case, the electric power of the transmit signal is adjusted by the variable gain amplifying unit 13 and the power amplification unit 15.

On the other hand, when the route B has been selected the last time and until now, the control unit 19 maintains the selection of the other route B. The control unit 19 then determines the power gain of the variable gain amplifying unit 13 according to the electric power P of the transmit signal (in step ST3).

In this case, the electric power of the transmit signal is adjusted by only the variable gain amplifying unit 13.

In performing step ST2, when determining that the electric power P > the threshold A, the control unit 19 reads a control procedure for raising the electric power of the transmit signal from the memory 20 (in steps ST4 and ST5).

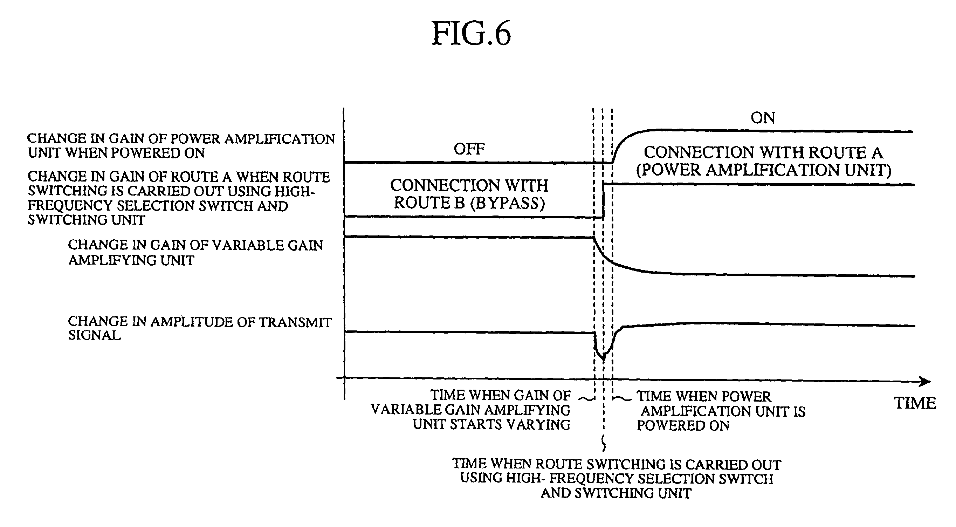

In this case, when the route B has been selected the last time and until now, as shown in Fig. 6, the control unit reads a control procedure for reducing the power gain of the variable gain amplifying unit 13, then switching from the route B to the route A, and, after that, turning on the power supply of the power amplification unit 15.

Thereby, the control unit 19 outputs a switching command for selection of the route A to the high-frequency selection switch 14 and the switching unit 16 after outputting a control signal for instructing a reduction in the power gain to the variable gain amplifying unit 13. After that, the control unit 19 outputs a control signal for turning on the power supply of at least one amplifier to the power amplification unit 15 (step ST6). In the above-mentioned example, the control unit 19 turns on the power supply of at least one amplifier in the power amplification unit 15 after switching from the route B to the route A. As an alternative, the control unit 19 can switch from the route B to the route A after turning on the power supply of at least one amplifier in the power amplification unit 15.

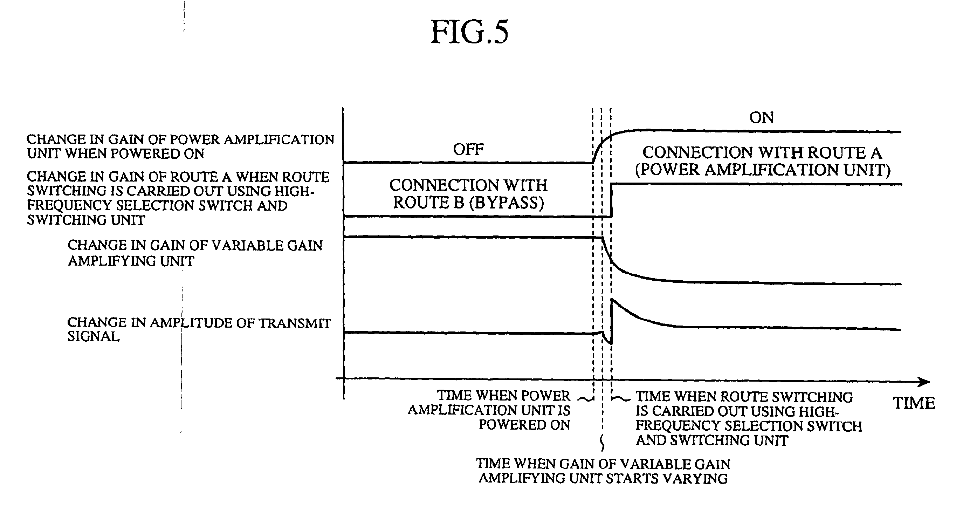

Since the electric power of the transmit signal changes steeply and the same problem as that with prior art communication apparatus arises if control processing is carried out according to a control procedure as shown in Fig. 5 in a case the electric power of the transmit signal is raised, such a control procedure is not stored in the memory 20.

When determining that the electric power P > the threshold A and the route A has been selected the last time and until now, the control unit maintains the selection of the route A. Then, while determining the power gain of the variable gain amplifying unit 13 according to the electric power P of the transmit signal, the control unit 19 determines one or more amplifiers which are to be powered on in the power amplification unit 15. In this case, the electric power of the transmit signal is adjusted by the variable gain amplifying unit 13 and the power amplification unit 15.

On the other hand, when determining that the electric power P < the threshold B, the control unit 19 reads a control procedure for reducing the electric power of the transmit signal from the memory 20 (in steps ST4 and ST7).

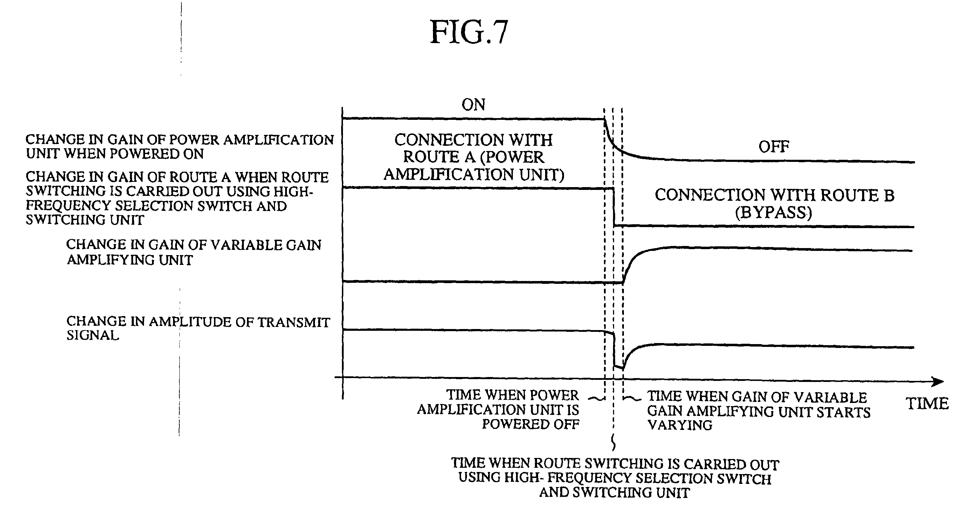

In this case, when the route A has been selected the last time and until now, as shown in Fig. 7, the control unit reads a control procedure for turning off the power supply of the power amplification unit 15, then switching from the route A to the route B, and, after that, raising the power gain of the variable gain amplifying unit 13.

As a result, the control unit 19 outputs a switching command for instructing selection of the route B to the high-frequency selection switch 14 and the switching unit 16 after outputting a control signal for turning off the power supplies of all amplifiers included in the power amplification unit 15. After that, the control unit 19 outputs a control signal for raising the power gain to the variable gain amplifying unit 13 (in step ST8). As an alternative, after raising the power gain of the variable gain amplifying unit 13, the control means can turn off the power supplies of all amplifies included in the power amplification unit 15 and then switch from the route A to the route B.

When determining that the electric power P < the threshold B and the route B has been selected the last time and until now, the control unit maintains the selection of the route B. Then, according to the electric power P of the transmit signal, the control unit determines the power gain of the variable gain amplifying unit 13. In this case, the electric power of the transmit signal is adjusted by only the variable gain amplifying unit 13.

As can be seen from the above description, in accordance with this embodiment 1, the control unit 19 is so constructed as to read a control procedure for changing the electric power of the transmit signal from the memory 20 and to control the variable gain amplifying unit 13, the power amplification unit 15, the high-frequency selection switch 14, and the switching unit 16 according to the control procedure. Therefore, the present embodiment offers an advantage of being able to prevent steep changes in the electric power of the transmit signal, thereby reducing the consumed electric current without degradation in the communication performance.

In accordance with this embodiment 1 shown, the threshold B smaller than the threshold A, as well as the threshold A, are used, as previously mentioned. This is because the turning on and off operations of the power supply of the power amplification unit 15 are made to have hysteresis characteristics, thereby preventing frequent occurrence of route switching. The threshold A and the threshold B can be so set as to have an identical value.

In addition, in accordance with this embodiment 1, the two routes are provided, as previously mentioned. The number of routes disposed in the communication apparatus is not limited to two, and three or more routes can be provided.

The reason why the control unit controls each component in turn according to the control procedure, which is not explained above, is that changes in the gain of the communication apparatus at the time of route switching using the high frequency selection switch 14 and the switching unit 16 and changes in the amplification characteristics of the variable gain amplifying unit 13 and the power amplification unit 15 are not constant and it is impossible to control all the components simultaneously, and therefore the electric power of the transmit signal varies with time.

### Embodiment 2.

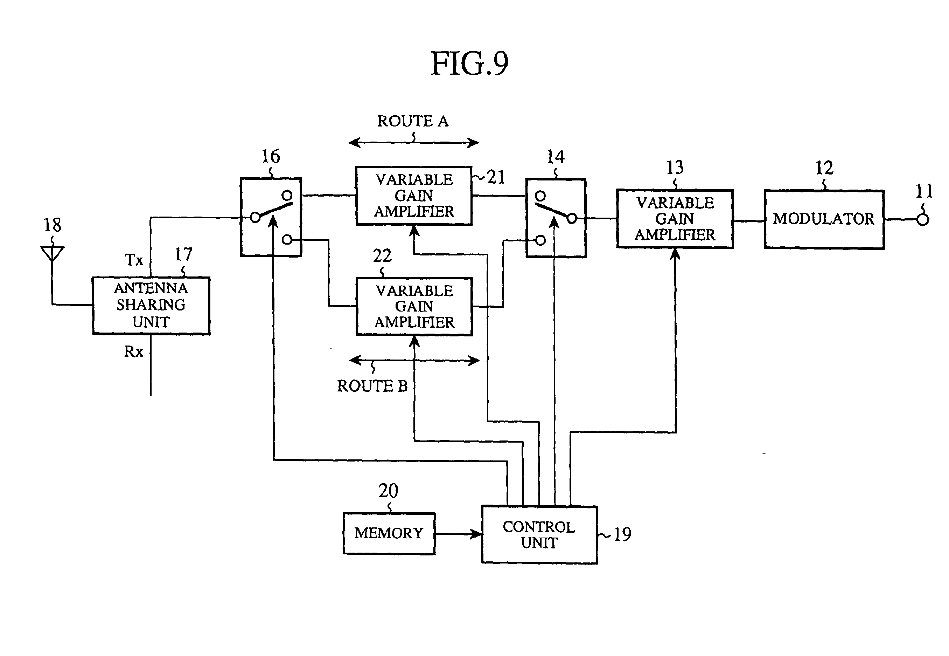

Fig. 9 is a block diagram showing a communication apparatus in accordance with embodiment 2 of the present invention. In the figure, the same reference numerals as shown in Fig. 3 denote the same components as those of embodiment 1 or like components, and therefore the explanation of these components will be omitted hereafter.

Reference numeral 21 denotes a variable gain amplifying unit (i.e., a power amplification means) installed on a route A, for adjusting the electric power of a transmit signal output thereto from a variable gain amplifying unit 13 under the control of a control unit 19, and reference numeral 22 denotes a variable gain amplifying unit (i.e., a bypass means) installed on a route B, for adjusting the electric power of the transmit signal output thereto from the variable gain amplifying unit 13 under the control of the control unit 19.

The variable gain amplifying unit 22 can amplify the transmit signal with a gain smaller than that with which the variable gain amplifying unit 21 can amplify the transmit signal, and has a smaller amount of consumed electric current than the variable gain amplifying unit 21.

Next, the operation of the communication apparatus in accordance with embodiment 2 of the present invention will be explained.

Although the communication apparatus in accordance with embodiment 2 differs from that in accordance with embodiment 1 in that the variable gain amplifying unit 22 is disposed on the route B, and the variable gain amplifying unit 21 is disposed on the route A instead of the power amplification unit 15, the communication apparatus in accordance with embodiment 2 basically operates in the same way as that in accordance with embodiment 1.

In accordance with this embodiment 2, when the transmit signal has low electric power, that is, when the route B is selected by a high-frequency selection switch 14 and a switching unit 16, the control unit turns on the power supply of the variable gain amplifying unit 22 while turning off the power supply of the variable gain amplifying unit 21. In this case, since not only the variable gain amplifying unit 13 but the variable gain amplifying unit 22 can perform gain control, unlike the communication apparatus in accordance with above-mentioned embodiment 1, the power consumption at the time of low electric power output can be reduced and the dynamic range of the variable gain amplifying unit 13 can be significantly reduced.

In addition, when the transmit signal has high electric power, that is, when the route A is selected by the high-frequency selection switch 14 and the switching unit 16, the control unit turns on the power supply of the variable gain amplifying unit 21 while turning off the power supply of the variable gain amplifying unit 22. In this case, since not only the variable gain amplifying unit 13 but the variable gain amplifying unit 21 can perform gain control, unlike the communication apparatus in accordance with above-mentioned embodiment 1, the dynamic range of the variable gain amplifying unit 13 can be significantly reduced.

### Embodiment 3.

As previously mentioned, in the communication apparatus in accordance with above-mentioned embodiment 1, the control unit 19 reads a control procedure for changing the electric power of the transmit signal from the memory 20, and controls the variable gain amplifying unit 13, the power amplification unit 15, the high-frequency selection switch 14, and the switching unit 16 according to the control procedure. In contrast, in accordance with embodiment 3, when switching between two routes by using a high-frequency selection switch 14 and a switching unit 16, a control unit can gradually change the electric power of a transmit signal by controlling the power gain of a variable gain amplifying unit 13 and the power supply voltage of a power amplification unit 15 so that they change gently.

As a result, the present embodiment offers an advantage of being able to, when changing the electric power of the transmit signal, prevent steep changes in the electric power of the transmit signal more effectively as compared with above-mentioned embodiment 1.

As previously mentioned, since the control unit controls the power gain of the variable gain amplifying unit 13 and the power supply voltage of the power amplification unit 15 so that they change gently, the communication apparatus of this embodiment can prevent steep changes in the electric power of the transmit signal more effectively as compared with prior art communication apparatus when changing the electric power of the transmit signal, even though the control unit controls the variable gain amplifying unit 13, the power amplification unit 15, the high-frequency selection switch 14, and the switching unit 16 without following the preset control procedure.

### Embodiment 4.

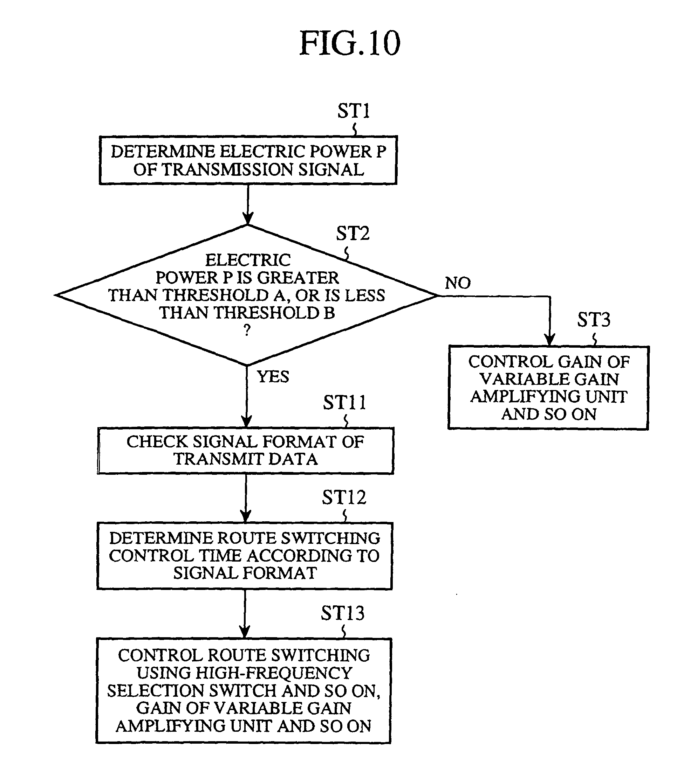

Fig. 10 is a flow chart showing processing performed by a communication apparatus in accordance with embodiment 4 of the present invention.

As previously mentioned, in the communication apparatus in accordance with above-mentioned embodiment 1, the control unit 19 reads a control procedure for changing the electric power of the transmit signal from the memory 20, and controls the variable gain amplifying unit 13, the power amplification unit 15, the high-frequency selection switch 14, and the switching unit 16 according to the control procedure. In contrast, in accordance with this embodiment 4, when switching between routes by using a high-frequency selection switch 14 and a switching unit 16, a control unit 19 can check the signal format of a transmit signal, determine a switching control time when route switching control is to be carried out (i.e., a time when changing the destination of the transmit signal) according to the signal format, and switch between the two routes at the switching control time.

Concretely, the control unit 19 performs the above-mentioned operations.

In general, the transmit signal is comprised of message data, control information data about control of communications, etc., and is transmitted to the communication apparatus with two or more types of data included in the transmit signal being separated with respect to time.

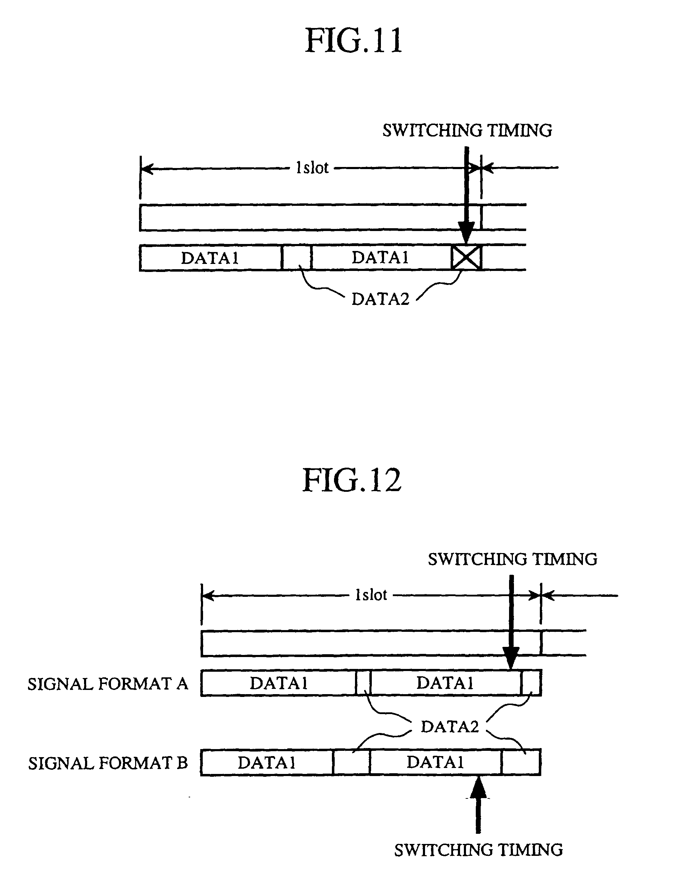

As mentioned above, the electric power of the transmit signal changes rapidly when the communication apparatus switches between the two routes. Therefore, as shown in Fig. 11, data contained in the transmit signal may be lost when the communication apparatus switches between the two routes.

In a case where the lost data is important for the current communication link or the transmit signal has a little amount of information, the lost data may significantly interfere with the current communication link and the demodulation performance of the base station may degrade. When the communication apparatus switches between the two routes, since switching control takes place at the same switching control time (i.e., at the same switching timing) for every slot and the type of data at the switching control time is also identical, the type of data that may be lost at the time of route switching is also identical. Accordingly, every time when the communication apparatus switches between the two routes, the same type of data may be lost and the current communication link may encounter trouble.

Therefore, by setting the switching control timing for each slot so that switching between the two routes is carried out when transmitting data which does not cause big trouble in the communication link based on the signal format of the transmit signal on a physical channel, the degradation of the quality of the communication link can be prevented to some extent.

However, when the signal format of the transmit signal on the physical channel changes with a change or the like in the data speed of the transmit signal during communications, data that can cause big trouble in the communication link may reach the high-frequency selection switch at the preset switching control timing of a slot.

In accordance with this embodiment 4, even if the signal format of the transmit signal on the physical channel changes with a change or the like in the data speed of the transmit signal during communications, in order to avoid big communications trouble, the control unit operates as follows.

In other words, when comparing the electric power P of the transmit signal with two thresholds A and B, and then determining that there is a necessity to switch between the two routes, as in the case of above-mentioned embodiment 1, the control unit 19 refers to format information (i.e., format information may be input, independently of the transmit signal, to an input terminal 11) indicating the signal format of the transmit signal, which is contained in the transmit signal input from the input terminal 11, and checks the signal format of the transmit signal on the physical channel (in step ST11).

For example, when the transmit signal is comprised of data1 and data2, as shown in Fig. 12, and big trouble can occur in the communication link if the data2 is lost, the control unit 19 grasps the location of the data2 in the checked signal format and determines the switching control time (i.e., the switching timing) so that switching Between the two routes is not carried out at the time of transmission of the data2 (in step ST12).

Then, when the switching timing comes, the control unit 19 controls the high-frequency selection switch 14 and the switching unit 16 so as to perform route switching, and also controls the gain of the variable gain amplifying unit 13 and so on (in step ST13).

As can be seen from the above description, in accordance with this embodiment 4, the communication apparatus is so constructed that the control unit 19 checks the signal format of the transmit signal, determines a switching control time when carrying out switching between the two routes according to the signal format, and causing the high-frequency selection switch 14 and the switching unit 16 to switch between the two routes at the switching control time. Therefore, the present embodiment offers an advantage of being able to reduce the consumed electric current without causing losses in important data which cause big trouble in the communication link.

### Embodiment 5.

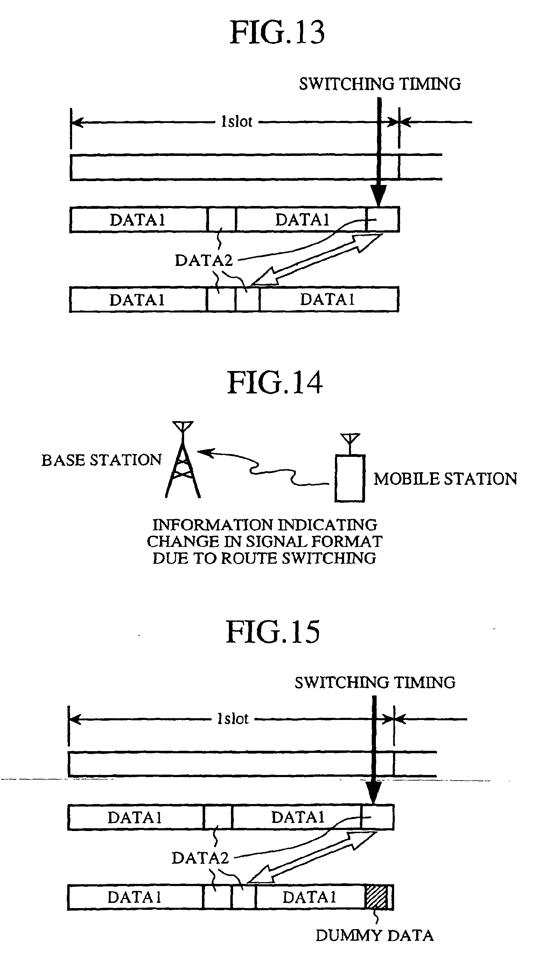

In accordance with above-mentioned embodiment 4, when switching between the two routes by using the high-frequency selection switch 14 and the switching unit 16, the control unit 19 can check the signal format of a transmit signal, determine a switching control time when route switching control is to be carried out according to the signal format, and switch between the two routes at the switching control time, as previously mentioned. In contrast, in accordance with this embodiment, when outputting a switching command for switching between two routes to a high-frequency selection switch 14 and a switching unit 16, a control unit 19 transmits a request for change of the signal format of a transmit signal to a source apparatus which has sent the transmit signal to the communication apparatus, as shown in Fig. 13, in order not to switch between the two routes when data which causes big trouble in the communication link reaches the high-frequency selection switch.

In other words, in a case where it is predicted that, if a current signal format is maintained, the control unit will switch between the two routes at timing when data which causes big trouble in the communication link will reach the high-frequency selection switch, the control unit 19 switches between the two routes after the source apparatus has changed the signal format of the transmit signal.

When the signal format of the transmit signal has been changed, the control unit 19 transmits information indicating the new signal format to the base station, as shown in Fig. 14. As a result, the base station can surely demodulate the received signal even if the signal format of the transmit signal has been changed.

Instead of simply changing the signal format of the transmit signal, as shown in the example of Fig. 13, the control unit can insert dummy data which does not affect the communication link even if the dummy data is lost, as shown in Fig. 15, into a location corresponding to the switching control time, thereby preventing the degradation of the demodulation performance of the base station.

### Embodiment 6.

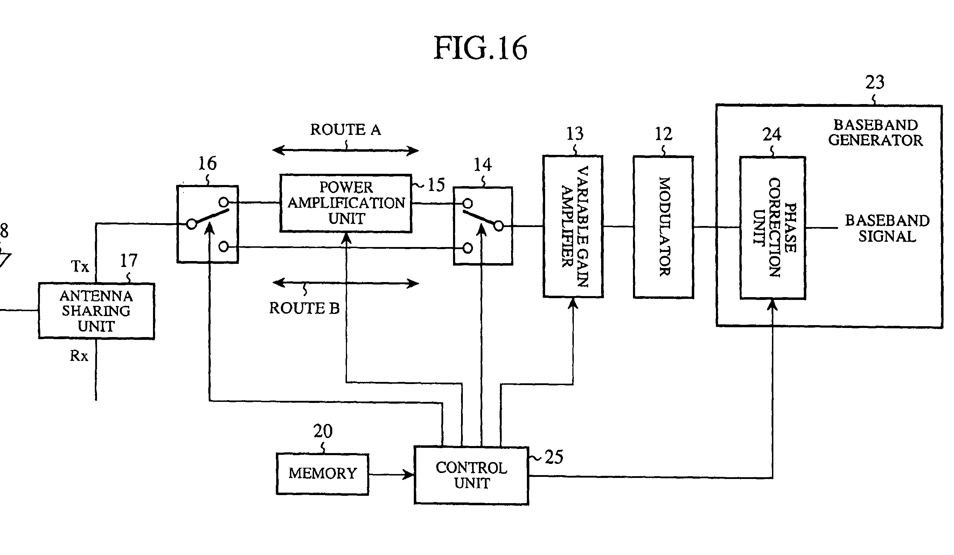

Fig. 16 is a block diagram showing a communication apparatus in accordance with embodiment 6 of the present invention. In the figure, the same reference numerals as shown in Fig. 3 denote the same components as those of embodiment 1 or like components, and therefore the explanation of these components will be omitted hereafter.

Reference numeral 23 denotes a baseband signal generator for generating a transmit signal which is a baseband signal, reference numeral 24 denotes a phase correction unit (i.e., a phase correction means) built in the baseband signal generator 23, for correcting the phase of the transmit signal when a control unit switches between two routes by using a high-frequency selection switch 14 and a switching unit 16, and reference numeral 25 denotes the control unit (i.e., a control means and a phase correction means) which has the same function as the control unit 19 of above-mentioned embodiment 1, and also has a function of outputting a correction command indicating a degree of phase to be corrected to the phase correction unit 24.

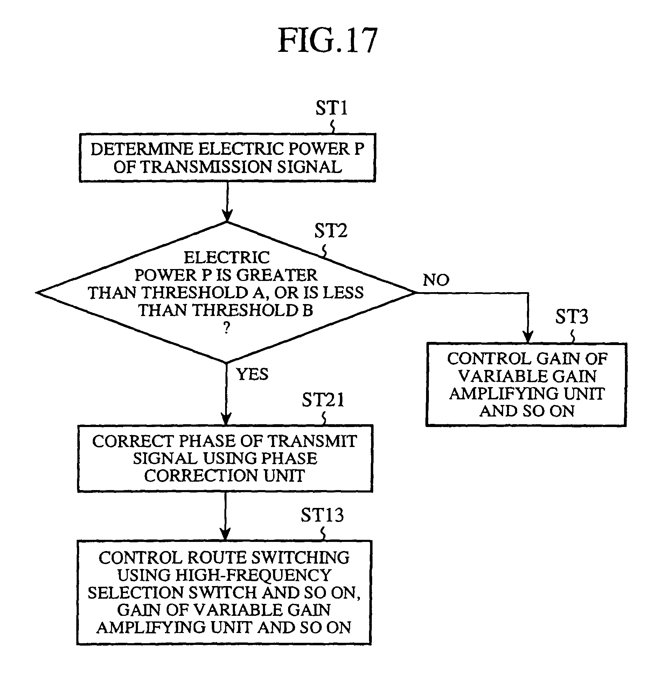

Fig. 17 is a flow chart showing processing performed by the communication apparatus in accordance with embodiment 6 of the present invention.

Next, the operation of the communication apparatus in accordance with embodiment 6 of the present invention will be explained.

Although no mention is made of changes in the phase of the transmit signal in above-mentioned embodiment 1, when the control unit switches between the two routes by using the high-frequency selection switch 14 and the switching unit 16, the phase of the transmit signal can change greatly. For this reason, when the base station demodulates the transmit signal, a detection error may occur and therefore data which has reached the high-frequency selection switch of the communication apparatus at the time of route switching may be lost. As a result, big trouble may occur in the communication link.

To solve this problem, in accordance with this embodiment 6, when carrying out route switching by using the high-frequency selection switch 14 and the switching unit 16, the control unit 25 outputs a correction command indicating a degree of phase to be corrected, which corresponds to a change in the phase of the transmit signal incident to the route switching to the phase correction unit 24, and the phase correction unit 24 corrects the phase of the transmit signal according to the correction command (in step ST21).

Therefore, the communication apparatus can reduce changes in the phase of the transmit signal which are incident to the route switching.

### Industrial Applicability

As mentioned above, the communication apparatus in accordance with the present invention carries out communications smoothly while reducing its power consumption, by appropriately adjusting the electric power of a transmit signal input thereto according to the distance from a mobile station in which the communication apparatus is mounted to a base station and propagation environments, and is suitable for use in mobile stations such as mobile phones.

## Claims

1. A communication apparatus including an electric power adjustment means for adjusting electric power of a transmit signal, a power amplification means for receiving the transmit signal whose electric power is adjusted by the electric power adjustment means and for amplifying the transmit signal and outputting it to an antenna, a bypass means for receiving the transmit signal whose electric power is adjusted by the electric power adjustment means and for outputting the transmit signal to the antenna, and a switching means for delivering the transmit signal output thereto from the electric power adjustment means to either the power amplification means or the bypass means,
**characterized in that** a control procedure for changing the electric power of the transmit signal is preset, and the apparatus comprises a control means for controlling the electric power adjustment means, the power amplification means, and the switching means according to the control procedure.

2. The communication apparatus according to Claim 1,
**characterized in that** after reducing a power gain of the electric power adjustment means, the control means allows the switching means to change the destination of the delivery of the transmit signal from the bypass means to the power amplification means, and also allows the power amplification means to amplify the transmit signal.

3. The communication apparatus according to Claim 1,
**characterized in that** after prohibiting the power amplification means from amplifying the transmit signal, the control means allows the switching means to change the destination of the delivery of the transmit signal from the power amplification means to the bypass means.

4. The communication apparatus according to Claim 1,
**characterized in that** the power amplification means is comprised of a variable gain amplifying unit, and the bypass means is comprised of a variable gain amplifying unit.

5. The communication apparatus according to Claim 1,
**characterized in that** the control means gradually changes the electric power of the transmit signal when allowing the switching means to change the destination of the delivery of the transmit signal.

6. A communication apparatus including an electric power adjustment means for adjusting electric power of a transmit signal, a power amplification means for receiving the transmit signal whose electric power is adjusted by the electric power adjustment means and for amplifying the transmit signal and outputting it to an antenna, a bypass means for receiving the transmit signal whose electric power is adjusted by the electric power adjustment means and for outputting the transmit signal to the antenna, and a switching means for delivering the transmit signal output thereto from the electric power adjustment means to either the power amplification means or the bypass means,
**characterized in that** the apparatus comprises a control means for, when causing the switching means to change the destination of the delivery of the transmit signal, checking a format of the transmit signal, determining a switching time when switching the destination of the delivery of the transmit signal according to the format, and causing the switching means to change the destination of the delivery of the transmit signal at the determined switching time.

7. The communication apparatus according to Claim 1,
**characterized in that** when causing the switching means to change the destination of the delivery of the transmit signal, the control means transmits a request for change of the format of the transmit signal.

8. A communication apparatus including an electric power adjustment means for adjusting electric power of a transmit signal, a power amplification means for receiving the transmit signal whose electric power is adjusted by the electric power adjustment means and for amplifying the transmit signal and outputting it to an antenna, a bypass means for receiving the transmit signal whose electric power is adjusted by the electric power adjustment means and for outputting the transmit signal to the antenna, and a switching means for delivering the transmit signal output thereto from the electric power adjustment means to either the power amplification means or the bypass means,
**characterized in that** the apparatus comprises a phase correction means for correcting a phase of the transmit signal output to the electric power adjustment means when the switching means changes the destination of the delivery of the transmit signal.
